# EUROPEAN PATENT SPECIFICATION

(11) **EP 1 426 813 B1**
(45) Date of publication and mention of the grant of the patent: **21.08.2013**
(21) Application number: 03026735.5
(22) Date of filing: 21.11.2003
(51) Int. Cl.: G02F 1/1362, H01L 21/84, H01L 27/12, H05B 33/12

(54) **Light-emitting device, and methods of manufacturing a semiconductor device**
Lichtemittierende Vorrichtung und Herstellungsverfahren für eine Halbleitervorrichtung
Dispositif électroluminescent et procédés de fabrication d'un dispositif semiconducteur

(30) Priority: 22.11.2002 JP 2002339952
(43) Date of publication of application: 09.06.2004
(73) Proprietor: Semiconductor Energy Laboratory Co., Ltd., Atsugi-shi, Kanagawa-ken 243-0036 (JP)
(72) Inventor: Yamazaki, Shunpei, Atsugi-shi Kanagawa-ken 243-0036 (JP); Takayama, Toru, Atsugi-shi Kanagawa-ken 243-0036 (JP); Tsurume, Takuya, Atsugi-shi Kanagawa-ken 243-0036 (JP); Goto, Yuugo, Atsugi-shi Kanagawa-ken 243-0036 (JP)
(74) Representative: Grünecker, Kinkeldey, Stockmair & Schwanhäusser

(56) References cited:
- EP-A- 1 122 794
- EP-A- 1 256 983
- US-A- 5 359 441

## Description

### BACKGROUND OF THE INVENTION

### 1. Field of the Invention

The present invention relates to devices and manufacturing methods for a semiconductor device, a display device, and a light-emitting device each of which is composed of a plurality of thin film transistors (hereinafter, a TFT) covered by an organic thin film. A semiconductor device according to the present invention includes a CPU, (Central Processing Unit), an MPU (Micro Processor Unit), a memory, a microcomputer, and an image processor. A display device according to the present invention includes a liquid crystal display device, PDP (Plasma Display Panel), FED (Field Emission Display), or the like.

### 2. Related Art

In recent years, techniques for forming a TFT using a semiconductor thin film (having a thickness of from approximately several to several hundreds nm) formed over a substrate having an insulating surface has been attracted attention. A TFT is utilized widely for an electronic device such as an IC, an optical device, or the like.

EP 1 256 983 A discloses a flexible monolithic integrated circuit formed from flexible circuit elements. Connecting elements interconnect the individual components of the circuit. The circuit has a flexible coating comprising at least one layer of a polymeric material.

US 5 359 441 A discloses a reflection type liquid crystal display apparatus which is capable of displaying bright images by decreasing the loss of projected light. The reflection type liquid crystal display apparatus employs a polymer dispersed liquid crystal (PDLC) panel which assures a display mode (scattering or absorption mode) which does not employ a polarizing film.

EP 1 122 794 A discloses a technology for manufacturing a high performance electric device using a plastic support (including a plastic film and a plastic substrate) wherein after necessary elements for a light emitting device are formed on a substrate having better heat resistance than plastic with a separating layer and an underlayer film interposed therebetween, the elements and the underlayer film are moved from the substrate having better heat resistance onto a plastic support having color filters thereon by a process at room temperature. Color filters are attached to the underlayer film of the elements using an adhesive layer.

As a substrate for forming these TFTs, a glass substrate or a quartz substrate is widely used now, however, theses substrates have some drawbacks such as being fragile and heavy. Further, these substrates are unsuitable for mass-production since it is difficult to form these substrates into large-sized. Therefore it has been attempted that a device composed of TFTs is formed over a substrate having flexibility as typified by a flexible plastic film.

However, the process maximum temperature should be lowered since the heat resistance of a plastic film is low, with the result that a TFT having better electric characteristics than that of a TFT formed over a glass substrate cannot be formed. Thus, a semiconductor device, a display device, or a light-emitting device including a TFT which is directly formed over a substrate has not been realized yet.

At the same time, techniques for forming a thin film device over a glass substrate or a quartz substrate, and exfoliating the thin film device (exfoliated body) from the substrate, and then transferring to a transferred body such as a plastic substrate, etc are disclosed. (For example, Unexamined Patent Publication No. 10-125929)

If a semiconductor device, a display device, or a light-emitting device can be manufactured over a substrate having flexibility such as a plastic film, these devices can be utilized for a display of being thin, lightweight, flexible, and curved, so that the range of application can be broaden out.

By utilizing the above-described technique for transferring, a layer (hereinafter, a device formation layer) comprising a semiconductor device (CPU, MPU, a memory, a microcomputer, an image processor, or the like), a display device (a liquid crystal display device, PDP, FED, or the like), or a light-emitting device each of which has TFT with good electric characteristics can be manufactured over a transferred body such as a plastic, or the like. However, such transferred body is unsuitable for sealing an exfoliated body since the transferred body such as a plastic formed of an organic material is permeable for moisture, oxygen, or the like.

### SUMMARY OF THE INVENTION

In view of the foregoing, it is an object of the present invention to provide devices and manufacturing methods for a semiconductor device, a display device, and a light-emitting device each of which has a structure that is capable of preventing moisture, oxygen, or the like, from outside from penetrating into a device formation layer, in addition to a structure of being thin, lightweight, and curved flexible.

The present invention provides a light-emitting device comprising:
a device formation layer comprising:
   a thin film transistor formed over a first insulating film;
   an interlayer insulating film formed over the thin film transistor; and
   a first electrode electrically connected to the thin film transistor via the interlayer insulating film;
   an electroluminescent layer formed over the first electrode; and
   a second electrode formed over the electroluminescent layer;
   a first fluoroplastic film formed in contact with the first insulating film; and
   a second fluoroplastic film formed over the second electrode,
   wherein the second fluoroplastic film is in contact with the first fluoroplastic film.

Further, it is provided a method for manufacturing a semiconductor device comprising:
forming a device formation layer including a plurality of thin film transistors over a first substrate;
forming a first adhesive layer in contact with the device formation layer;
bonding a second substrate to the first adhesive layer, and sandwiching the device formation layer between the first substrate and the second substrate;
splitting and removing the first substrate from the device formation layer by a physical means;
forming a first fluoroplastic film over an exposed surface by sputtering;
bonding a third substrate to the first fluoroplastic film with a second adhesive layer interposed therebetween;
splitting and removing the first adhesive layer and the second substrate from the device formation layer;
forming a second fluoroplastic film over an exposed surface of the device formation layer by sputtering; and
splitting and removing the second adhesive layer and the third substrate from the device formation layer.

### BRIEF DESCRIPTION OF THE DRAWINGS

FIG. 1 is an explanatory drawing showing the structure of a semiconductor device according to the present invention;
FIGS. 2A to 2C are explanatory drawings showing a method for manufacturing a semiconductor device according to the present invention;
FIGS. 3A to 3C are explanatory drawings showing a method for manufacturing a semiconductor device according to the present invention;
FIGS. 4A to 4C are explanatory drawings showing a method for manufacturing a semiconductor device according to the present invention;
FIGS. 5A to 5D are explanatory drawings showing a process for manufacturing a TFT;
FIGS. 6A to 6D are explanatory drawings showing a process for manufacturing a TFT;
FIGS. 7A to 7C are explanatory drawings showing a structure of an external connection of a semiconductor device according to the present invention;
FIGS. 8A to 8B are explanatory drawings showing a light-emitting device according to the present invention;
FIGS. 9A to 9G are explanatory drawings showing applied products using a semiconductor device or the like according to the present invention;
FIGS. 10A to 10D are explanatory drawings showing ESCA measured results of a fluoroplastic film;
FIGS. 11A to 11D are explanatory drawings showing ESCA measured results of a fluoroplastic film;
FIG. 12 is an explanatory drawing showing IR measured results of a fluoroplastic film; and
FIG. 13 is an explanatory drawing showing a structure of a semiconductor device according to the present invention.

### DESCRIPTION OF THE PREFERRED EMBODIMENTS

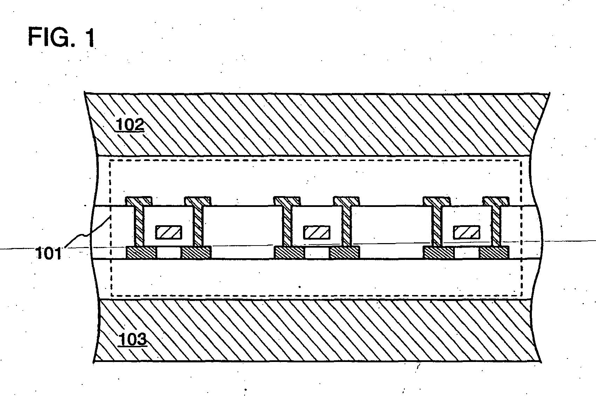

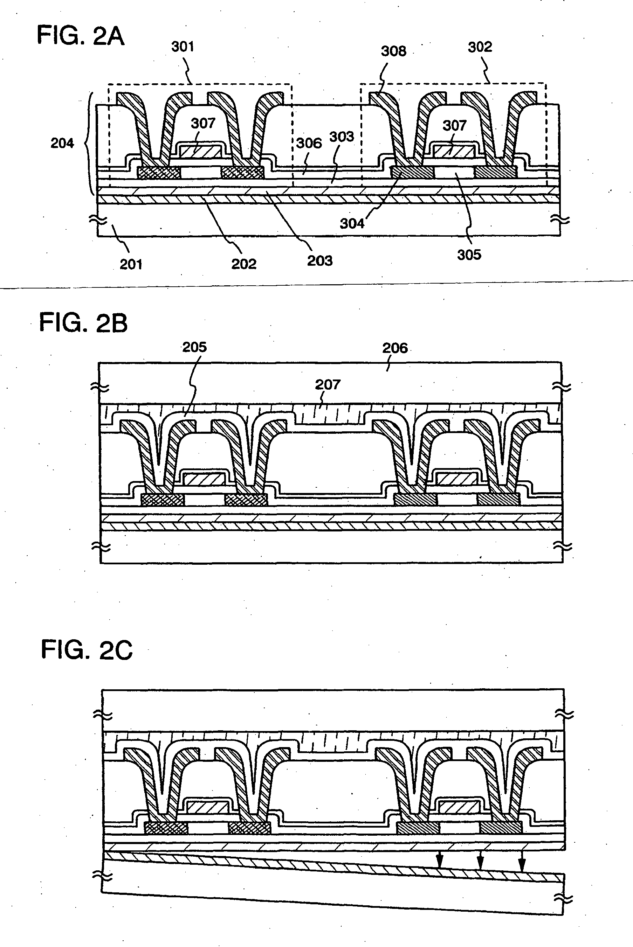

FIG. 1 is a view showing the structure of a semiconductor device manufactured according to the present invention. Thus, the semiconductor device has the structure in which a device formation layer 101 comprising a combination of a plurality of TFTs is covered by fluoroplastics films 102 and 103. A method for manufacturing such semiconductor device will be described in detail with reference to FIGS. 2 to 4.

FIG. 2A is a view of showing a state in which a metal layer 202 and an oxide layer 203 are sequentially formed over a first substrate 201, and a device formation layer 204 is formed- thereon.

As the first substrate 201, a glass substrate, a quartz substrate, a ceramic substrate, or the like can be used. In addition, a silicon substrate, a metal substrate, or a stainless substrate can also be used.

As materials for the metal layer 202 formed over the first substrate 201, an element selected from the group consisting of W, Ti, Ta, Mo, Nd, Ni, Co, Zr, Zn, Ru, Rh, Pd, Os, Ir, and Pt; a single layer formed of an alloy material or a compound material containing these elements as its main components; a lamination layer of the single layers; or nitride, for example, a single layer or a lamination layer formed of titanium nitride, tungsten nitride, tantalum nitride, or molybdenum nitride. The metal layer 202 is formed to have a thickness of from 10 to 200 nm, preferably, from 50 to 75 nm.

In case of forming a metal layer 202 by sputtering, the thickness of the first substrate 201 at the vicinity of its periphery portion is tend to be inhomogeneous since the first substrate 201 is fixed. Therefore, it is preferable that only the periphery portion is removed by dry etching. In this regard, an insulating film formed of an oxynitride silicon film can be formed to have a thickness of approximately 100 nm between the substrate 201 and the metal layer 202 to prevent the first substrate 201 from being etched.

The oxide layer 203 formed over the metal layer 202 is formed by using silicon oxide, silicon oxynitride, and metal oxide materials by sputtering. The thickness of the oxide layer 203 is preferably more than twice as large as that of the metal layer 202. For example, a silicon oxide film is preferably formed to have a thickness of from 150 to 200 nm by sputtering using silicon oxide targets.

A device formation layer 204 formed over the oxide layer 203 is the layer in which a semiconductor device, a display device, or a light-emitting device is formed by combining appropriately TFTs (a p-channel TFT 301 and an n-channel TFT 302). Each p-channel TFT 301 and the n-channel TFT 302 is composed of a gate insulating film 306, a gate electrode 307, and a wiring 308, in addition to a base film 303, an impurity region 304 formed in a part of a semiconductor film, and a channel formation region 305.

In the process for forming the device formation layer 204, heat treatment is carried out at least after forming a material film containing hydrogen (a semiconductor film or a metal film) to diffuse the hydrogen. The heat treatment may be carried out at least 410°C. The heat treatment may be carried out separately from the process for forming the device formation layer 204, or simultaneously for simplification of processes. For example, in case of using an amorphous silicon film containing hydrogen as a material film, and heating the amorphous silicon film to form a polysilicon film, hydrogen in the amorphous silicon film can be diffused by the heat treatment at least 500 °C while crystallizing the amorphous silicon film to form a polysilicon film.

Then, a nitride layer 205 is formed over the device formation layer 204. Here, the nitride layer 205 is formed to have a thickness of approximately 50 nm by sputtering.

A second substrate 206 which is a support medium for fixing the device formation layer 204 and a nitride layer 205 is bonded with a first adhesive layer 207 (FIG. 2B). As the second substrate 206, a semiconductor substrate as typified by a silicon substrate or a metal substrate as typified by a stainless substrate in addition to a glass substrate, a quartz substrate, a ceramic substrate, or a plastic substrate, can be used. The second substrate 206 is preferably having stronger rigidity than that of the first substrate 201.

As a material for the first adhesive layer 207, various curing adhesives such as a photo-curing adhesive, for example, a reaction-curing adhesive, a thermal-curing adhesive, or a UV-curing adhesive, or an anaerobic adhesive can be used. In addition, it is preferable that these adhesives be soluble in water or organic solvent and be sensitive to light, that is, the adhesive be formed of the material that the adhesiveness weakens by light irradiation. As the composition of these adhesives, for example, epoxy base, acrylate base, silicon base, or the like can be applied. In addition, the first adhesive layer 207 is formed by coating, or the like. The first adhesive layer 207 will be removed in the following process.

In this embodiment mode, as a material for the first adhesive layer 207, an adhesive layer which is soluble in water or organic solvent is used.

But not exclusively, a two-sided tape (which is sensitive to light; that is, the adhesiveness of the two-sided tape weakens by light irradiation) or a combination of the two-sided tape and the above-described adhesives can be used as a material for the first adhesive layer 207.

The first substrate 201 provided with the metal layer 202 is split off (FIG. 2C). The first substrate 201 can be split off by comparatively small force since the membrane stress of the oxide layer 203 and the metal layer 202 are different each other.

According to this, the device formation layer 204 formed over the oxide layer 203 can be split off from the first substrate 201 and the metal layer 202.

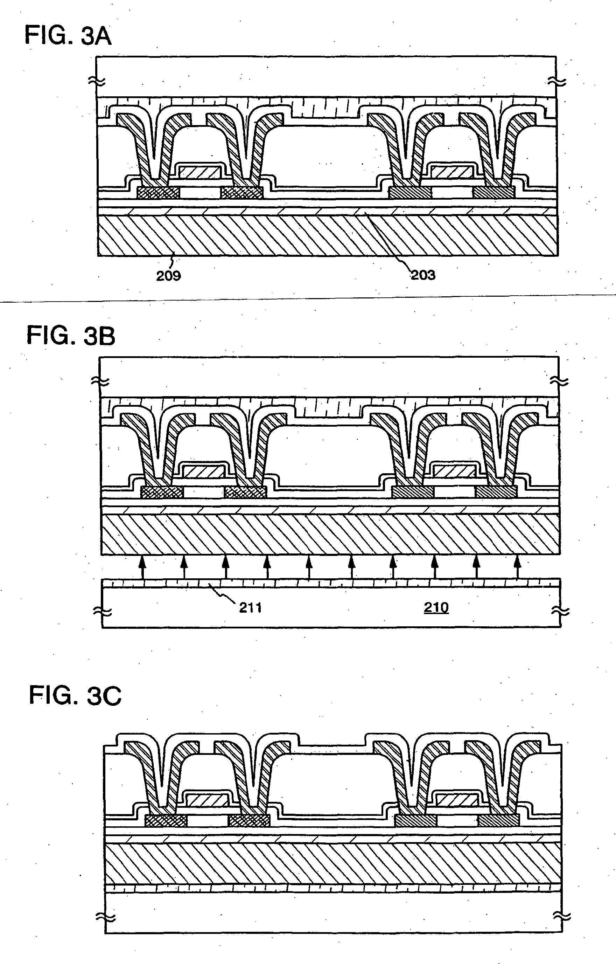

Next, a fluoroplastic film 209 can be formed by sputtering over the surface of the oxide layer 203 which is exposed by splitting off (FIG. 3A). A nitride layer 208 can be formed prior to forming the fluoroplastic film 209.

The fluoroplastic film 209 deposited by sputtering under the conditions, that is, Ar gas used as process gas is 30 sccm (the 5 sccm O₂ gas can be used in addition to the Ar gas); sputtering pressure used is 0.4 Pa; electric power, 400 W; and the substrate temperature, 300°C. The fluoroplastic film 209 is formed to have a thickness of from 1 to 100 µm.

For forming the fluoroplastic film 209 according to the present invention, the target of polytetrafluoroethylene, tetrafluoroethylene-hexafluoropropylene copolymer, polychlorotrifluoroethylene, tetrafluoroethylene-ethylene copolymer, polyvinyl fluoride, polyvinylidene fluoride, or the like is used.

In case of forming the fluoroplastic film 209 by coating such as spin-coating, fluoroplastic solution using water as solvent (liquid fluoroplastic resin coating) can be used.

The formation of the fluoroplastic film 209 has a favorable effect on device characteristics of TFTs included, in the device formation layer 204 (although not shown, it would be a light-emitting device in case of having a light-emitting device) and prevents the penetration of moisture or gas such as oxygen causing deterioration.

A third substrate 210 is bonded to the fluoroplastic film 209 with a second adhesive layer 211 (FIG. 3B). As a material for the third substrate 210, the same material as that of the second substrate 206 can be used. As a material for the second adhesive layer 211, the same material as that of the first adhesive layer 207 can also be used. As the second adhesive layer 211, a two-sided tape which is sensitive to light, that is, the adhesiveness of the two-sided tape weakens by light irradiation, is used for bonding the third substrate 210 to the fluoroplastic film 209.

Then, the second substrate 206 and the first adhesive layer 207 are removed (FIG. 3C). If the adhesive used for the first adhesive layer 207 is soluble in water or organic solvent, the adhesive is removed by cleaning with water or organic solvent, and then the second substrate 206 is split off. If the adhesive used for the first adhesive layer has photosensitivity, that is, the adhesiveness weakens by the light irradiation, and then the second substrate 206 is split off. Further, if a combination of a two-sided tape and adhesive which is soluble in water is used, firstly, light may be irradiated in order to weak the adhesiveness of the two-sided tape, secondly, the second substrate 206, the device formation layer 204, or the like may be split off, and thirdly, the adhesive that is soluble in water remained over the device formation layer 204 or the like may be removed by water washing.

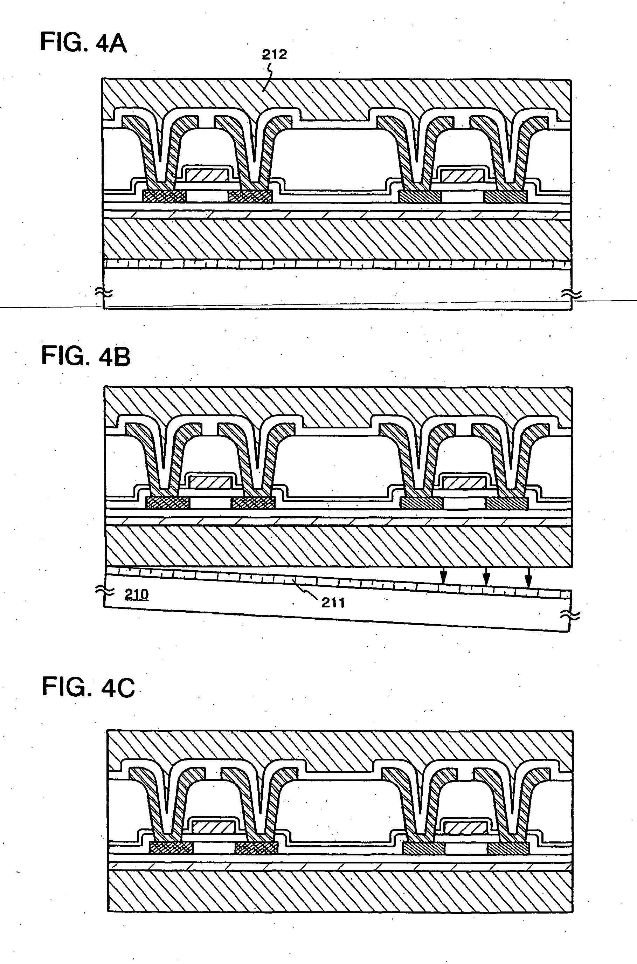

A fluoroplastic film 212 is formed by sputtering on the nitride layer 205 which is exposed by removing the second substrate and the first adhesive layer 207 (FIG. 4A). The fluoroplastic film 212 can be formed by using the same material and the same method as those of the fluoroplastic film 209.

A semiconductor device having a structure shown in FIG. 4C is manufactured by splitting off the third substrate 210 and the second adhesive layer 211 from the device formation layer 204 or the like by means of weakening the adhesiveness of the two-sided tape by irradiating light from side of the third substrate 210.

### Embodiments

Embodiments of the present invention will be described hereinafter.

### [Embodiment 1]

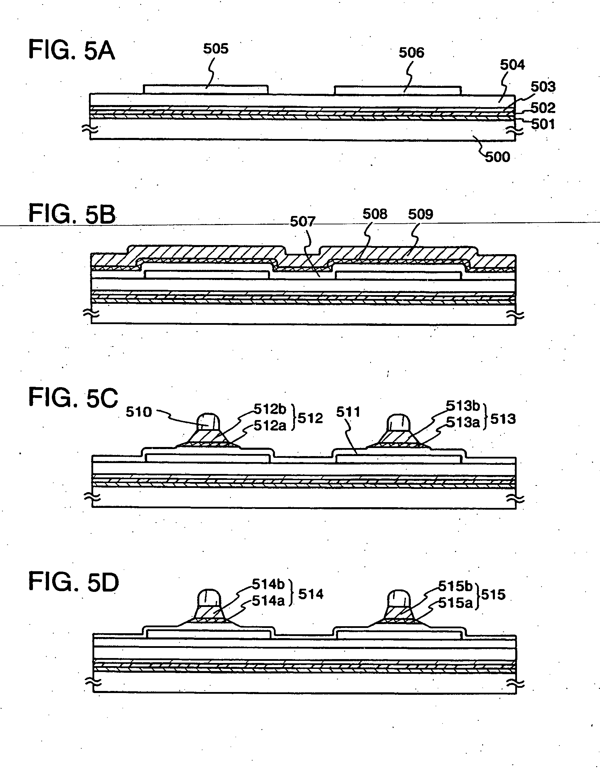

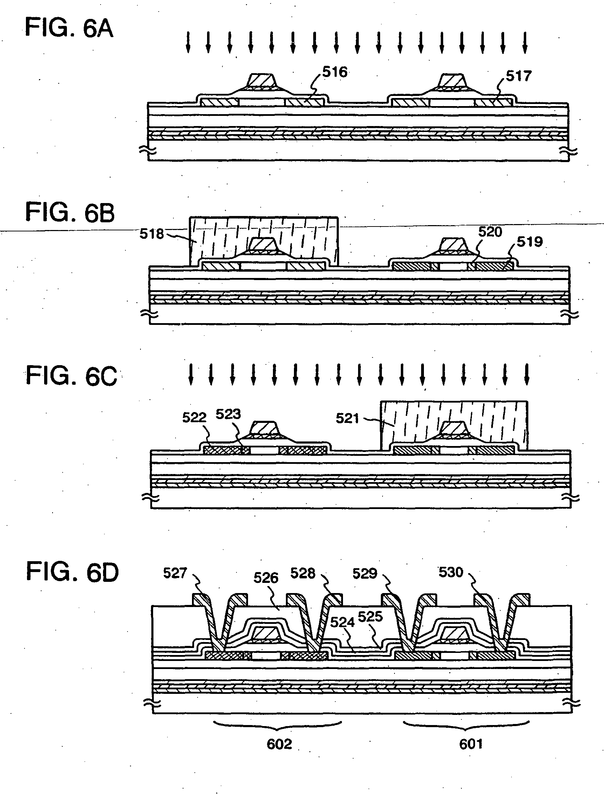

Embodiments of the present invention will be described with reference to FIGS. 5 and 6. A method for forming simultaneously an n-channel TFT and a p-channel TFT over one substrate will be described in detail hereinafter.

A quartz substrate, a semiconductor substrate, a ceramic substrate, a metal substrate, or the like, may be used as a substrate 500. In this embodiment, a glass substrate (#1737) is used for the substrate 500. First, a silicon oxynitride layer is formed to have a thickness of 100 nm over the substrate 500 by PCVD as a nitride layer 501.

Subsequently, a tungsten layer is formed to have a thickness of 50 nm by sputtering as a metal layer 502, and an oxide layer 503 to have a thickness of 200 nm is formed continuously by sputtering as a silicon oxide layer without being exposed to the atmosphere. The silicon oxide layer is formed under the condition, that is, using a RF sputtering device; using a silicon oxide target (diameter is 30.5 cm); flowing a heated argon gas at a flow rate of 30 sccm for heating the substrate; setting the substrate temperature at 300 °C; the pressure of film formation at 0:4 Pa; the electric power at 3 kW; and argon flow rate/oxygen flow rate = 10 sccm/30 sccm.

Subsequently, the tungsten layer at periphery or edges of the substrate is removed using O₂ ashing.

Subsequently, a silicon oxynitride film formed of SiH₄ and N₂O as material gases (composition ratio: Si=32%, O=59%, N=7%, H=2%) is stacked to have a thickness of 100 nm at deposition temperature of 300 °C by plasma CVD. Further, a semiconductor film having an amorphous configuration (in this case, amorphous silicon film) is formed to have a thickness of 54 nm without exposure to an atmosphere using SiH₄ as deposition gas and at deposition temperature of 300 °C by plasma CVD. This amorphous silicon film contains hydrogen, the hydrogen will be diffused by a subsequent heat treatment, and the amorphous silicon film can be peeled in the oxide layer or the interface of the oxide layer by a physical means.

Then, a nickel acetate salt solution containing nickel of 10 ppm in weight is coated using a spinner. Instead of the coating, a method of spraying nickel elements to the entire surface by sputtering may also be used. Then, heat treatment is carried out for crystallization to form a semiconductor film having a crystalline configuration (here, a polysilicon layer is formed). Here, after the heat treatment (500 °C for 1 hour) for dehydrogenation is carried out, and the heat treatment (550 °C for 4 hours) for crystallization is carried out, and then, a silicon film having a crystalline configuration is formed. Also, the heat treatment (500 °C for 1 hour) for dehydrogenation has a function, which is diffusing the hydrogen contained in the amorphous silicon layer into an interface with the tungsten film and silicon oxide layer. Also note that, although a crystallization technique using nickel as a metal element that promotes crystallization of silicon is used here, other known crystallization techniques, for example, a solid-phase growth method and a laser crystallization method, may be used.

Next, after the oxide film on the surface of the silicon film having a crystalline configuration is removed by dilute hydrofluoric acid or the like, laser beam (XeCl: wavelength of 308 nm) is irradiated for raising a crystallization rate and repairing defects remaining in crystal grains in the atmosphere or in the oxygen atmosphere. Excimer laser beam with a wavelength of 400 nm or less, or second harmonic wave or third harmonic wave of a YAG laser is used as the laser beam. In any case, pulse laser beam with a repetition frequency of approximately from 10 to 1000 Hz is used, the pulse laser beam is condensed to from 100 to 500 mJ/cm² by an optical system, and irradiation is performed with an overlap ratio of from 90 to 95%,. whereby the silicon film surface may be scanned. Here, laser beam is irradiated in the atmosphere with a repetition frequency of 30 Hz and energy density of 470 mJ/cm².

Note that an oxide film is formed over the surface since laser beam is irradiated in the atmosphere or in the oxygen atmosphere. Though an example of using the pulse laser is shown here, the continuous oscillation laser may also be used. When a crystallization of an amorphous semiconductor film is carried out, it is preferable that the second harmonic through the fourth harmonic of basic waves are applied by using the solid state laser which is capable of continuous oscillation in order to obtain a crystal in large grain size. Typically, it is preferable that the second harmonic (with a thickness of 532 nm) or the third harmonic (with a thickness of 355 nm) of an Nd: YVO₄ laser (basic wave of 1064 nm) may be applied. Specifically, laser beams emitted from the continuous oscillation type YVO₄ laser with 10 W output is converted into a harmonic by using the non-linear optical elements. Also, a method for emitting a harmonic by applying crystal of . YVO₄ and the non-linear optical elements into a resonator can be applied. Then, more preferably, the laser beams are formed to have a rectangular shape or an elliptical shape by an optical system and a substance is exposed to the laser beam. At this time, the energy density of approximately from 0.01 to 100 MW/cm² (preferably, from 0.1 to 10 MW/cm²) is required. The semiconductor film is moved at approximately from 10 to 2000 cm/s rate relatively corresponding to the laser beams so as to expose to the laser beam.

In addition to the oxide film formed by this laser beam irradiation, an oxide film is formed by treating the surface with ozone water for 120 seconds as a barrier layer to have a thickness of from 1 to 5 nm in total. Though the barrier layer is formed by using ozone water here, another method such as ultraviolet light irradiation in an oxygen atmosphere or oxide plasma treatment for oxidizing the surface of the semiconductor film having the crystal structure may be used. In addition, as another method for forming the barrier layer, an oxide film having a thickness of approximately from 1 to 10 nm may be deposited by plasma CVD, a sputtering method, an evaporation method, or the like. Further, prior to forming the barrier layer, the oxide film formed by laser beam irradiation may be removed.

Over the barrier layer, an amorphous silicon film containing argon elements, which serves as a gettering site, is formed to have a thickness of from 10 to 400 nm, in this embodiment, 100 nm by sputtering. In this embodiment, an amorphous silicon film containing argon is formed under the atmosphere containing argon with using a silicon target. In case of forming an amorphous silicon film containing argon elements by plasma CVD, it is formed under the condition, that is, a flow ratio of monosilane to argon is controlled to be 1/99; a pressure during deposition to be 6.665 Pa (0.05 Torr); a RF power density during deposition to be 0.087 W/cm²; and a deposition temperature to be 350 °C.

Then, an oven heated at 650 °C is used for heat treatment for 3 minutes for gettering to lower the nickel concentration in the semiconductor film having a crystal structure. A lamp annealing apparatus may be used instead of the oven.

Subsequently, the amorphous silicon film containing argon elements, which serves as a gettering site, is selectively removed using the barrier layer as an etching stopper, and then, the barrier layer is selectively removed by dilute hydrofluoric acid. Note that there is a tendency that nickel moves toward a region with a high oxygen concentration during gettering, and thus, it is desirable that the barrier layer formed of the oxide film is removed after gettering.

Then, after a thin oxide film is formed by using ozone water on the surface of the obtained silicon film having a crystal structure (also referred to as a polysilicon film), and a mask formed of resist is formed, then island-like semiconductor layers 505 and 506 isolated in island shapes are formed by etching to have desired shapes. After forming the semiconductor layers 505 and 506, the mask formed of resist is removed.

Through the above processes, a nitride layer 501, a metal layer 502, an oxide layer 503, and a base insulating film 504 are formed on a substrate 500, and a semiconductor film having a crystal structure is formed, then, semiconductor layers 505 and 506 isolated in island shapes are formed by etching to have desired shapes.

Then, the oxide film is removed with the etchant containing hydrofluoric acid, and at the same time, the surface of the silicon film is cleaned. Thereafter, an insulating film containing silicon as its main components, which serves as a gate insulating film 507, is formed. In this embodiment, a silicon oxynitride film (composition ratio: Si=32%, O=59% N=7%, H=2%) is formed with a thickness of 115 nm by plasma CVD (FIG. 5B).

Next, a first conductive film 508 with a thickness of from 20 to 100 nm and a second conductive film 509 with a thickness of from 100 to 400 nm are stacked over the gate insulating film 507. In this embodiment, tantalum nitride film with a thickness of 50 nm and a tungsten film with a thickness of 370 nm are sequentially stacked over the gate insulating film 507.

As a conductive material for forming the first conductive film 508 and the second conductive film 509, an element selected from the group consisting of Ta, W, Ti, Mo, A1 and Cu, or an alloy material or a compound material containing the above elements as its main components is employed. Further, as a first conductive film 508 and a second conductive film 509, a semiconductor film as typified by a polycrystal silicon film added with an impurity element such as phosphorus, or an AgPdCu alloy may be used. Further, the present invention is not limited to a two-layer structure. For example, a three-layer structure may be adopted in which a tungsten film with a thickness of 50 nm, an alloy film of aluminum and silicon (Al-Si) with a thickness of 500 nm, and a titanium nitride film with a thickness of 30 nm are sequentially stacked. Moreover, in case of a three-layer structure, tungsten nitride may be used instead of tungsten of the first conductive film, an alloy film of aluminum and titanium (Al-Ti) may be used instead of the alloy film of aluminum and silicon (Al-Si) of the second conductive film, and a titanium film may be used instead of the titanium nitride film of the third conductive film. In addition, a single layer structure may also be adopted.

Next, resist masks 510, 511 are formed in a light exposure process as shown in FIG. 5C. Then, a first etching treatment is carried out for forming gate electrodes and wirings. The first etching treatment is carried out under first and second etching conditions. ICP (inductively coupled plasma) etching is preferably used. The films can be etched to have desired taper shapes by using ICP etching and suitably adjusting the etching conditions (the amount of power applied to a coiled electrode, the amount of power applied to an electrode on the substrate side, the temperature of the electrode on the substrate side, etc.). As etching gas, chlorine-based gas as typified by Cl₂, BCl₃, SiCl₄, or CCl₄, fluorine-based gas as typified by CF₄, SF₆, or NF₃, or O₂ can be appropriately used.

In this embodiment, RF (13.56 MHz) power of 150 W is applied also to the substrate (sample stage) to substantially apply a negative self-bias voltage. The electrode area to the substrate side is 12.5 cm × 12.5 cm, and the coil-shape electrode area (quartz disc formed coil is described here) is 25 cm diameter disc. The W film is etched so as to form the edge portions of the first conductive layer in a taper shape under the first etching conditions. An etching rate to W is 200.39 nm/min, an etching rate to TaN is 80.32 nm/min, and a selection ratio of W to TaN is approximately 2.5 under the first etching conditions. Further, a taper angle of W becomes approximately 26° under the first etching conditions. Thereafter, the first etching conditions are changed to the second etching conditions without removing the masks 510, 511 formed of resist. CF₄ and Cl₂ are used as etching gases, the flow rate of the gas is set to 30/30 seem, and RF (13.56 MHz) power of 500 W is applied to a coil-shape electrode with a pressure of 1 Pa to generate plasma, thereby performing etching for about 30 seconds. RF (13.56 MHz) power of 20 W is also applied to the substrate side (sample stage) to substantially apply a negative self-bias voltage. Both the W film and the TaN film are etched at the same level under the second etching conditions in which CF₄ and Cl₂ are mixed. An etching rate to W is 58.97 nm/min, and an etching rate to TaN is 66.43 nm/min under the second etching conditions. Note that an etching time may be increased approximately to from 10 to 20% in order to etch without leaving residue over the gate insulating film.

In the first etching treatment as described above, the shape of the mask formed of resist is formed into an appropriate shape whereby each the edge portion of the first conductive layer and the edge portion of the second conductive layer is formed to have a tapered shape due to the effect of bias voltage applied to the substrate side. The angle of the tapered portion may be set ranging from 15° to 45°.

Thus, first shape conductive layers 512 and 513 composed of the first conductive layer and the second conductive layer (first conductive layers 512a and 513a and second conductive layers 512b and 513b) are formed by the first etching treatment. According to this, approximately from 10 to 20 nm of the insulating film 507, which serves as the gate insulating film, is etched and formed into a gate-insulating film 511 that except the region covered by the first shape conductive layers 512 and 513 is etched into a thin film.

Next, a second etching treatment is carried out for 25 seconds without removing the masks under the conditions, that is, SF₆, Cl₂ and O₂ are used as etching gas; the flow rate of the gas is set to 24/12/24 seem; and RF (13.56 MHz) power of 700 W is applied to a coil-shape electrode with pressure of 1.3 Pa to generate plasma. RF (13.56 MHz) power of 10 W is also applied to the substrate side (sample stage) to substantially apply a negative self-bias voltage. In the second etching treatment, an etching rate to W is 227.3 nm/min, an etching rate to TaN is 32.1 nm/min, a selection ratio of W to TaN is 7.1; an etching rate to SiON, which serves as the insulating film 511, is 33.7 nm/min, and a selection ration of W to SiON is 6.83. In case where SF₆ is used as etching gas, the selection ratio with respect to the insulating film 511 is ligh as described above. Thus, reduction in the film thickness can be suppressed. In this embodiment, the film thickness of the insulating film 511 is reduced by only approximately 8 nm.

Through the second etching treatment, the taper angle of W can be formed into have 70°. Through the second etching treatment, second conductive layers 514b and 515b are formed. On the other hand, the first conductive layers are hardly etched and formed into first conductive layers 514a, 515a. Note that the first conductive layers 514a, 515a have substantially the same sizes as those of the first conductive layers 512a, 513a. In actuality, the width of the first conductive layer may be reduced by approximately 0.3 µm, namely, approximately 0.6 µm in total, in comparison with the first conductive layer prior to being applied with the second etching treatment. There is almost no change in size of the first conductive layer.

Further, instead of the two-layer structure, in case that the three-layer structure is adopted in which a tungsten film with a thickness of 50 nm, an alloy film of aluminum and silicon (Al-Si) with a thickness of 500 nm, and a titanium nitride film with a thickness of 30 nm are sequentially stacked, the first etching treatment may be carried out for 117 seconds under the conditions, that is, BCl₃, Cl₂ and O₂ are used as raw material gases; the flow rate of the gases are set to 65/10/5 (seem); RF (13.56 MHz) power of 300 W is applied to the substrate side (sample stage); and RF (13.56 MHz) power of 450 W is applied to a coil-shape electrode with a pressure of 1.2 Pa to generate plasma. As to the second etching conditions in the first etching treatment, that is, CF₄, Cl₂ and O₂ are used; the flow rage of the gases is set to 25/25/10 seem; RF (13.56 MHz) power of 20 W is also applied to the substrate side (sample stage); and RF (13.56 MHz) power of 500 W is applied to a coil-shape electrode with a pressure of 1 Pa to generate plasma. The first etching treatment may be carried out for approximately 30 seconds under the second etching conditions. The second etching treatment may be carried out under the conditions, that is, BCl₃ and Cl₂ are used; the flow rate of the gases are set to 20/60 seem; RF (13.56 MHz) power of 100 W is applied to the substrate side (sample stage); and RF (13.56 MHz) power of 600 W is applied to a coil-shape electrode with a pressure of 1.2 Pa to generate plasma.

Next, the masks formed of resist are removed, and a first doping process is carried out to obtain the state of FIG. 6A. The doping process may be carried out by ion doping or ion implantation. Ion doping is carried out under the conditions of a dosage of 1.5 × 10¹⁴ atoms/cm² and an accelerating voltage of from 60 to 100 ke V. As an impurity element imparting n-type conductivity, phosphorus (P) or arsenic (As) is typically used. In such a case, first conductive layers and second conductive layers 514, 515 serve as masks against the impurity elements imparting n-type conductivity, and first impurity regions 516, 517 are formed in a self-aligning manner. The impurity element imparting n-type conductivity is added to the first impurity regions 516, 517 in a concentration range of from 1 × 10¹⁶ to 1 × 10¹⁷/cm³. Here, the region having the same concentration range as the first impurity region is also referred to as an n⁻⁻ region.

Note that although the first doping process is carried out after removing the masks formed of resist in this embodiment, the first doping process may be carried out without removing the masks formed of resist.

Subsequently, as shown in FIG. 6B, a mask 518 formed of resist is formed, and a second doping process is carried out. The mask 518 protects a channel forming region and the periphery thereof of a semiconductor layer forming a p-channel TFT.

The second doping process of phosphorus (P) is carried out under the conditions, that is, a dosage of 1.5 × 10¹⁵ atoms/cm², and an accelerating voltage of 60 to 100 keV Here, impurity regions are formed in the respective semiconductor layers in a self-aligning manner with the second conductive layers 514b, 515b as masks. Of course, phosphorus is not added to the regions covered by the mask 518. Thus, second impurity region 519 and a third impurity region 520 are formed. The impurity elements imparting n-type conductivity are added to the second impurity region 519 in a concentration range of 1 × 10²⁰ to 1 × 10²¹ /cm³. Here, the region having the same concentration range as the second impurity region is also referred to as an n⁺ region.

Further, the third impurity region 520 is formed to have a lower concentration than that in the second impurity region 519 by influence of the first conductive layer 515a, and is added with the impurity elements imparting n-type conductivity in a concentration range of 1 × 10¹⁸ to 1 × 10¹⁹ /cm³. Note that the third impurity region 520 is doped via the tapered portion of the first conductive layer so that the third impurity region 520 produces the concentration gradient in which the impurity concentration becomes higher toward the edge portion of the tapered portion. Here, the region having the same concentration range as that of the third impurity region is referred to as an n⁻ region.

Next, after the mask 518 formed of resist is removed, mask 521 formed of resist is newly formed, and a third doping process is carried out as shown in FIG. 6C..

The above-described third doping process is carried out, and fourth impurity region 522 and fifth impurity region 523 are formed in which an impurity elements imparting p-type conductivity are added to the semiconductor layer.

Further, the impurity element imparting p-type conductivity is added to the fourth impurity region 522 in a concentration range of from 1 × 10²⁰ to 1 × 10²¹ /cm³. Note that; in the fourth impurity region 522, phosphorus (P) has been added in the preceding step (n⁻ region), but the impurity element imparting p-type conductivity is added at 1.5 to 3 times the concentration of phosphorus. Thus, the fourth impurity region 522 has p-type conductivity. Here, the region having the same concentration range as the fourth impurity region 522 is also referred to as a p⁺ region.

Further, fifth impurity region 523 is formed in regions overlapping the tapered portion of the first conductive layer 515a, and is added with the impurity element imparting p-type conductivity in a concentration range of from 1 × 10¹⁸ to 1 × 10²⁰ /cm³. Here, the region having the same concentration range as the fifth impurity region 523 is also referred to as a p⁻ region.

Through the above-described steps, the impurity regions having n-type or p-type conductivity are formed in the respective semiconductor layers. The conductive layers 514,515 become gate electrodes of a TFT.

Next, an insulating film 524 that covers substantially the entire surface is formed. In this embodiment, a silicon oxide film is formed to have a thickness of 50 nm by plasma CVD. Of course, the insulating film is not limited to a silicon oxide film, and other insulating films containing silicon may be used in a single layer or a lamination structure.

Then, the process of activation treatment for the impurity element added to the respective semiconductor layers is carried out. In this activation process, a rapid thermal annealing (RTA) method using a lamp light source, a method for irradiating light emitted from a YAG laser or an excimer laser from the back surface, heat treatment using a furnace, or a combination thereof is employed.

Further, although an example in which the insulating film is formed before the activation is described in this embodiment, the insulating film may be formed after the activation is carried out.

Next, a first interlayer insulating film 525 formed of a silicon nitride film is formed, and heat-treated at the temperature of from 300 to 550°C for 1 to 12 hours, then, the process of hydrogenation of the semiconductor layers is carried out. (FIG. 6D) The hydrogenation is carried out for terminating dangling bonds of the semiconductor layers by hydrogen contained in the first interlayer insulating film 525. The semiconductor layers can be hydrogenated irrespective of the existence of an insulating film 524 formed of a silicon oxide film. Incidentally, in this embodiment, a material containing aluminum as its main components is used for the second conductive layer, and thus, it is important that hydrogenation is carried out under the conditions of heat treatment that the second conductive layer can withstand. As another means for hydrogenation, plasma hydrogenation (using hydrogen excited by plasma) may be adopted.

Next, a second interlayer insulating film 526 formed of an organic insulating material is formed over the first interlayer insulating film 525. In this embodiment, an acrylic resin film with a thickness of 1.6 µm is formed. Then, contact holes that reach the respective impurity regions are formed. In this embodiment, a plurality of etching treatments are sequentially carried out. In this embodiment, the second interlayer insulting film 526 is etched with the first interlayer insulating film 525 as the etching stopper, and the first interlayer insulating film 525 is etched with the insulating film 524 as the etching stopper, and then, the insulating film 524 is etched.

Thereafter, wirings 524, 528, 529 and 530 are formed by using Al, Ti, Mo, W, or the like.

According to this, an n-channel TFT 601 and a p-channel TFT 602 are formed over one substrate (FIG. 6).

Further, a CMOS circuit can be formed by connecting the n-channel TFT 601 and the p-channel TFT 602 to have a complementary structure.

In case of using a TFT that has the structure described in this embodiment in which the gate electrode and a part of an impurity region are overlapped with each other (GOLD structure), parasitic capacitance is increased due to the thin gate insulating film, however, if the parasitic capacitance is reduced by reducing the size of the part of the taper portion of a gate electrode (a first conductive layer), the frequency characteristics are improved, and higher speed operation and sufficient reliable TFT can be realized.

As described above, the process that is described in this embodiment mode of the present invention is carried out after the n-channel TFT 601 and a p-channel TFT 602 are formed over the substrate 500 so that a semiconductor device according to the present invention that has a structure in which a device formation layer including these TFTs covered by a fluoroplastic film can be manufactured.

The device formation layer including TFT formed according to this embodiment has a thickness of 50 µm or less.

### [Embodiment 2]

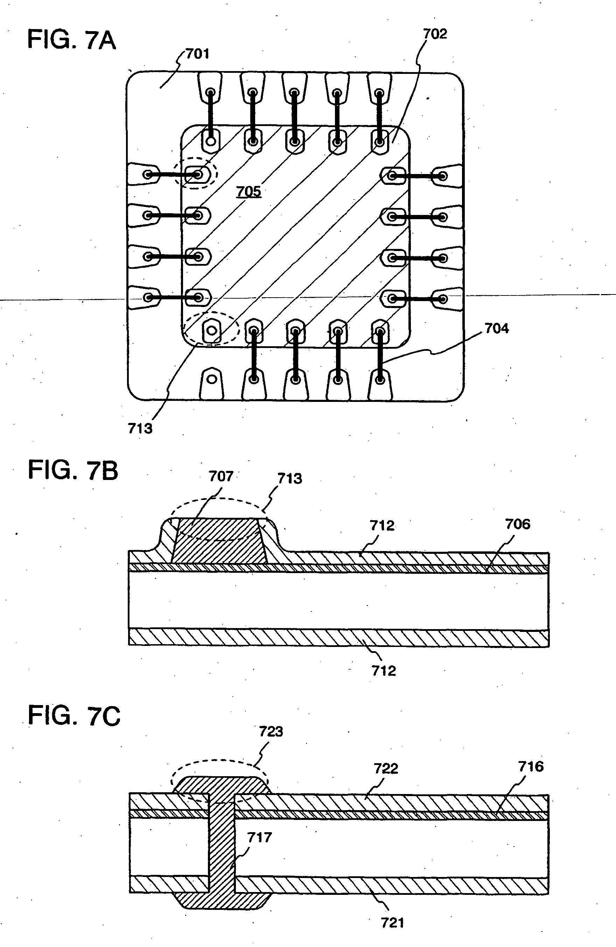

The case that a CPU is manufactured as a semiconductor device according to the present invention will be described with reference to FIG. 7 in this embodiment.

As shown in FIG. 7A, a CPU 705 formed of a combination of a plurality of TFTs is manufactured over a fluoroplastic film 701. Further, a fluoroplastic film 702 is formed over the CPU 705. The structure in which the CPU 705 is completely covered by these fluoroplastic films 701, 702 is explained. Adopting such structure, CPU 705 is completely secluded from the outside so that moisture, oxygen, or the like, from outside can be prevented from penetrating.

However, the CPU 705 is necessary to have a structure for connecting electrically with wiring. formed inside since the CPU is necessary to connect with the outside via a bonding wire 704, or the like.

In this embodiment, adopting such structure shown in FIG. 7B, a wiring 706 inside the CPU 705 is connected with the bonding wire 704 in an external connecting portion 713. In such a case, a metal 707 formed of a metal material having conductivity is formed prior to forming the fluoroplastic film 712, and the fluoroplastic film 712 is formed through the manufacturing method described in Embodiment Mode of the present invention.

The external connecting portion 713 can be formed by removing a part of the fluoroplastic film 712 that is formed over the metal 707.

As another structure, the structure shown in FIG. 7C can be adopted. In this case, an external connecting portion 723 having an electric connection with a wiring 716 can be formed by means of forming opening portions to the CPU 705 covered by the fluoroplastic films 712, 713 by using a physical means, and filling the opening portions with a metal 717.

The structure of an external connecting portion described in this embodiment is preferable illustrative only. The external connecting portion of the semiconductor device according to the present invention is not limited thereto. Therefore it is possible to select a process in which a fluoroplastic film is not formed only over the wiring, which serves as an external connecting portion.

### [Embodiment 3]

The semiconductor device according to the present invention has a thin, lightweight, and flexible structure so that a plurality of semiconductor devices can be used in combination with each other over one substrate. As used herein, the term "substrate" includes a flexible substrate such as a plastic film in addition to glass or quartz.

Thus, when the semiconductor device is CPU, a plurality of CPUs can be combined to be integrated over one substrate.

In addition, when a plurality of semiconductor devices are integrated over one substrate, the surface formed of a fluoroplastic film of the semiconductor device according to the present invention may be sputtered reversely to make the surface have depressions and projections, and each semiconductor device may be bonded to the substrate with adhesive.

### [Embodiment 4]

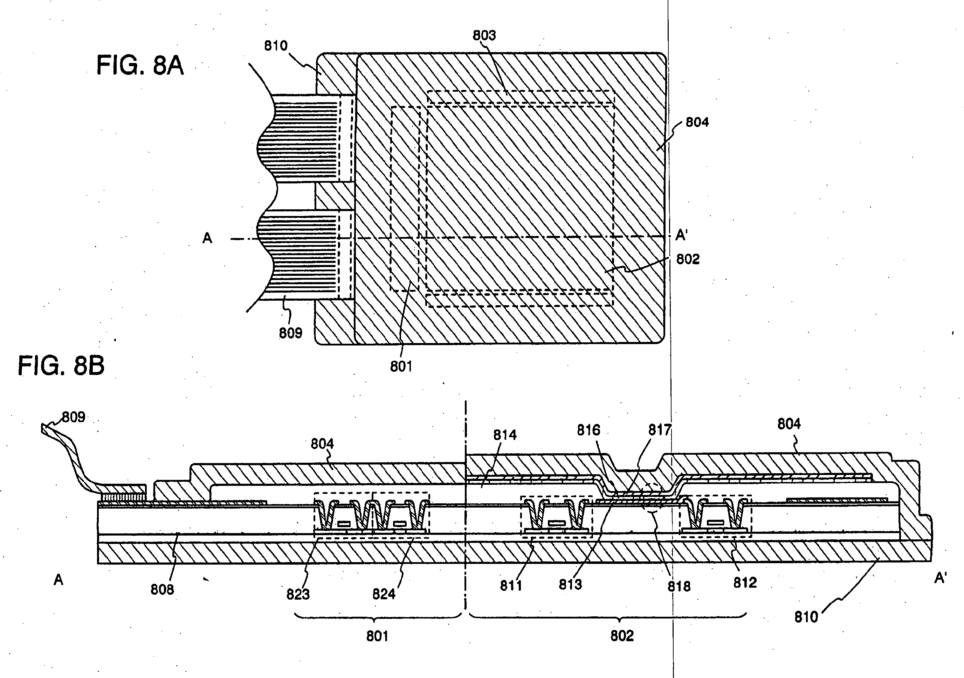

In Embodiment 4, the external view of an active matrix type light-emitting device will be described with reference to FIG. 8. FIG. 8A is a top surface view of a light-emitting device and FIG. 8B is a cross-sectional view taken along the line of A-A' of FIG. 8A. Reference numeral 801 indicated by a dotted line denotes a driver circuit portion (a source side driver circuit); 802, a pixel portion; 803, a driver circuit portion (a gate side driver circuit); 804, a fluoroplastic film.

Reference numeral 808 is a wiring for transmitting signals to be inputted to the source side driver circuit 801 and a gate side driver circuit 803. The wiring 808 receives a video signal, a clock signal, a start signal, a reset signal, or the like from the FPC (a flexible printed circuit) 809 that serves as an external input terminal. Though only the FPC is illustrated here, a PWB (a print wiring board) can be attached to the FPC. The light-emitting device in the specification includes not only a body of light-emitting device but also a light-emitting device in the state of being attached with FPC or PWB.

Next, a cross-sectional structure of a light emitting will be described with reference to FIG. 8B. Here, the source side driver circuit 801 portion that serves as a driver circuit portion and the pixel portion 802 are formed over a fluoroplastic film 810. The fluoroplastic film 810 is formed by sputtering, specifically, a fluoroplastic film such as polytetrafluoroethylene, tetrafluoroethylene-hexafluoropropylene copolymer, polychlorotrifluoroethylene, tetrafluoroethylene-ethylene copolymer, polyvinyl fluoride, polyvinylidene fluoride, or the like, can be used for forming the fluoroplastic film 810.

The source side driver circuit 801 is a CMOS circuit that is formed by combining an n-channel TFT 823 and a p-channel TFT 824. A TFT for forming a driver circuit may be formed of a known CMOS circuit, PMOS circuit, or NMOS circuit. A driver integrated type in which a driver circuit is formed over a fluoroplastic film is described in this embodiment, but not exclusively, the driver circuit may be formed outside.

The pixel portion 802 comprises a plurality of pixels that include a switching TFT 811, a current control TFT 812, and a first electrode 813 that connects electrically to a drain of the current control TFT 812. An insulator 814 is formed to cover the edge portion of the first electrode 813. Here, the insulator 814 is formed of a positive type photosensitive acrylic resin film.

To improve coverage, the upper edge portion or the bottom edge portion of the insulator 814 is formed to have a curved surface having curvature. For example, in case that the a positive type photosensitive acrylic is used as a material for the insulator 814, it is preferable that only the upper edge portion of the insulator 814 is formed to have a curved surface having radius of curvature (0.2 to 3 µm). Either a negative type that becomes an insoluble material in etchant according to light to which photosensitive material is exposed or a positive type that becomes a dissoluble material in etchant according to light for photosensitive material can be used as the insulator 814.

An electroluminescent layer 816 and a second electrode 817 are formed respectively over the first electrode 813. Here, as a material for forming the first electrode 813, it is preferable to use a large work function materials. For example, a single layer such as a titanium nitride film, a chrome film, a tungsten film, a Zn film, or Pt film; a lamination of a titanium nitride film and a film containing aluminum as its main components; or a three-layer lamination of a titanium nitride film, a film containing aluminum as its main components, and a titanium nitride film, are useful for the first electrode 813. By forming the first electrode to have a lamination structure, resistance as a wiring can be low, good properties of ohmic contact can be obtained, and the first electrode can be served as an anode.

The electroluminescent layer 816 can be formed by vapor deposition using an evaporation mask or ink-jetting.

As a material for the second electrode (cathode) 817 formed over the electroluminescent layer 816, a small work function material (Al, Ag, Li, Ca, or alloy of these materials such as MgAg, MgIn, AILi, CaF₂, or CaN) is useful. Here, the second electrode (cathode) 817 is formed of a lamination of a thin metal film, a transparent conductive film (Indium-tin-oxide (ITO), indium oxide-zinc oxide (In₂O₃-ZnO), zinc oxide (ZnO), or the like) in order light to pass through the second electrode.

The second electrode 817 serves as a wiring in common with all of the pixels and connects electrically to the FPC 809 via a connection wiring 808.

The fluoroplastic film 804 is formed by sputtering over the second electrode 817. The fluoroplastic film 804 is formed by using the same material as that of the above-described fluoroplastic film 810.

An inorganic insulating film can be formed prior to forming the fluoroplastic film 804. A silicon nitride film, a silicon oxide film, a silicon. oxynitride film (SiNO film (in a composition ratio of N>O) or SiON film (in a composition ratio of N<O)) or a thin film containing carbon as its main components (for example, a DLC film, a CN film, or the like) formed by sputtering, CVD, or vapor deposition may be useful for the inorganic insulating film.

Thus, the light-emitting device according to the present invention has a structure in which the fluoroplastic films 804, 810 cover the surface of the light-emitting device. Especially the electroluminescent layer among the light-emitting device 818 is easy to deteriorate due to moisture or oxygen. For this reason, it is beneficial for the light-emitting device 818 to be covered by the fluoroplastic films 804, 810 since moisture or gas such as oxygen or the like can be prevented from penetrating into the light-emitting device. Consequently, a high reliable light-emitting device can be obtained.

This embodiment can be implemented by freely combining a method for covering the device formation layer by the fluoroplastic film as described in Embodiment Mode of the present invention and a method for manufacturing the TFT as described in Embodiment 1. Further, this embodiment can be implemented through a method for connecting described in Embodiment 2 in the connecting portion of a FPC.

### [Embodiment 5]

A semiconductor device, a display device, or a light-emitting device (in this embodiment, referred to as a semiconductor device, or the like) according to the present invention is covered its surface by a fluoroplastic film instead of a substrate such as glass substrate, or a quartz substrate, or the like. The structure is different from the conventional one in which a semiconductor device is formed over a glass substrate, a quartz substrate, or the like. The structure according to the present invention has advantageous effect of preventing moisture, oxygen, or the like from outside from penetrating and realizing thin and lightweight and flexible structure. Therefore various applied products can be completed by utilizing the semiconductor device or the like according to the present invention.

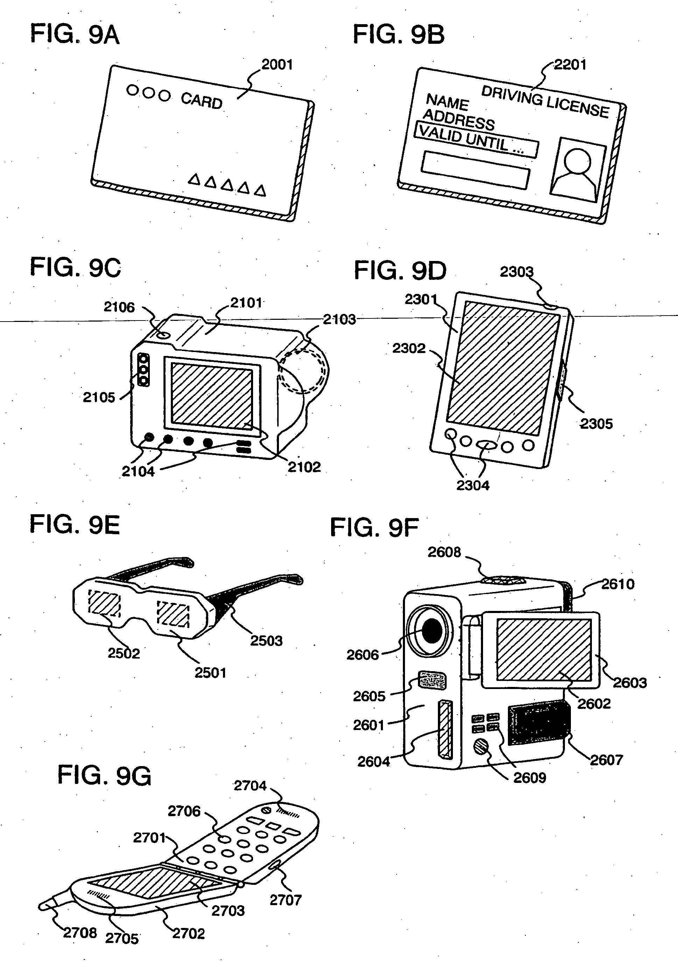

Given as examples of applied products manufactured by utilizing the semiconductor device or the like according to the present invention are: a prepaid card, a credit card, a driver's license, a wearable computer (a goggle type display, or a head mount display), a game machine, or an apparatus having a display device that can reproduce a recording medium and that can display the image of the above-described devices such as a portable information terminal (a mobile computer, a cellular phone, a portable game machine, an electronic book, or the like). Specific examples of the electric appliances are shown in FIG. 9A to 9G.

FIG. 9A shows a prepaid card, which can be manufactured by utilizing a semiconductor device or the like according to the present invention for the body 2001. Specifically, the semiconductor device can manage the usage of the card. In addition, the semiconductor device or the like according to the present invention is suitable for a prepaid card since it is thin, lightweight, and flexible, and provides portability.

FIG. 9B shows a driver's license, which can be manufactured by utilizing a semiconductor device or the like according to the present invention for the body 2201. Specifically, the semiconductor device can manage the driving record of the owner. In addition, the semiconductor device or the like according to the present invention is suitable for a driver's license since it is thin, lightweight, and flexible, and provides portability.

FIG. 9C shows a digital still camera which includes a main body 2101, a display portion 2102, an image receiving portion 2103, an operation key 2104, an external connection port 2105, a shutter 2106, or the like. The semiconductor device according to the present invention can be used for the display portion 2102.

FIG. 9D shows a mobile computer which includes a main body 2301, a display portion 2302, a switch 2303, an operation key 2304, an infrared port 2305, or the like. The semiconductor device according to the present invention can be used for the display portion 2303.

FIG. 9E shows a goggle type display (head mounted display) which includes a main body 2501, a display portion 2502, an arm portion 2503. The semiconductor device according to the present invention can be used for the display portion 2502.

FIG. 9F shows a video camera which includes a main body 2601, a display portion 2602, an casing 2603, an external connecting port 2604, a remote control receiving portion 2605, an image receiving portion 2606, a battery 2607, a sound input portion 2608, an operation key 2609, an eyepiece potion 2610, or the like. The semiconductor device according to the present invention can be used for the display portion 2602.

FIG: 9G shows a cellular phone which includes a main body 2701, a casing 2702, a display portion 2703, a sound input portion 2704, a sound output portion 2705, an operation key 2706, an external connecting port 2707, an antenna 2708, or the like. The semiconductor device according to the present invention can be used for the display portion 2703.

As set forth above, the semiconductor device manufactured according to the present invention has extreme wide application, so that the semiconductor device according to the present invention can be utilized to applied products in the various kinds of field.

### [Embodiment 6]

In Embodiment 6, measured results of the characteristics of the fluoroplastic film used in the present invention will be described. A film used for the measurement is the fluoroplastic film formed to have a thickness of 100 nm by using target of polytetrafluoroethylene by sputtering under the conditions, that is, Ar gas used as process gas is 30 sccm; sputtering pressure used is 0.4 Pa; electric power, 400 W; and the substrate temperature, 300 °C.

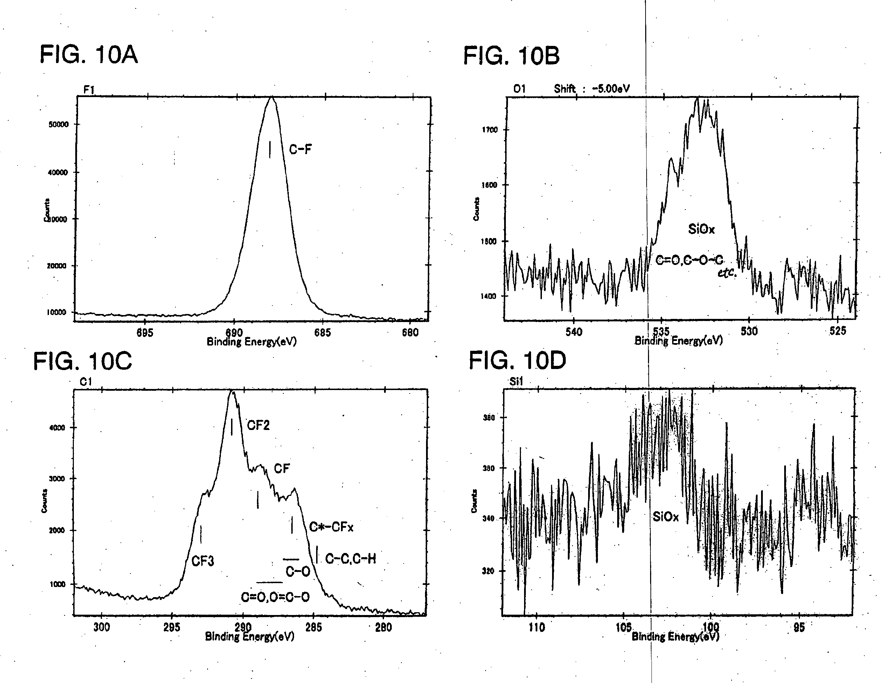

FIGS. 10A to 10D are views showing spectrums of ESCA (photoelectron spectroscopy for chemical analysis). Chemical composition of fluoride (F), oxygen (O) carbon (C), and silicon in the sample is in a ratio of 61:1:38. Silicon (Si) is not detected.

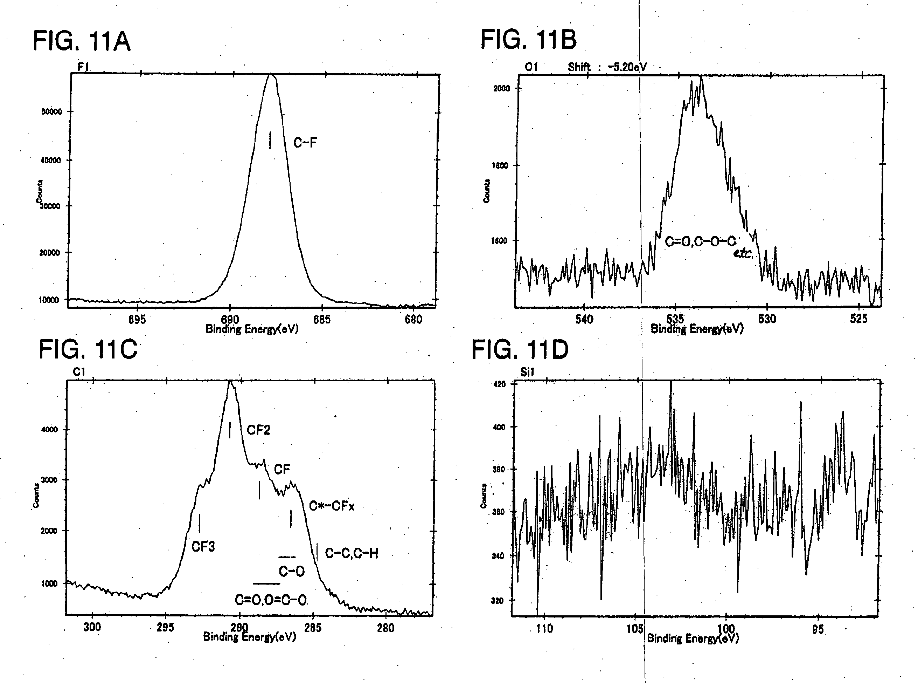

Measured results of a film formed by much the same measuring method in a different deposition condition is illustrated in FIGS. 11A to 11D. In this case, 30 seem Ar gas and 5 sccm O₂ gas are introduced. The composition ratio is the same as the condition illustrated in FIGS. 10A to 10D.

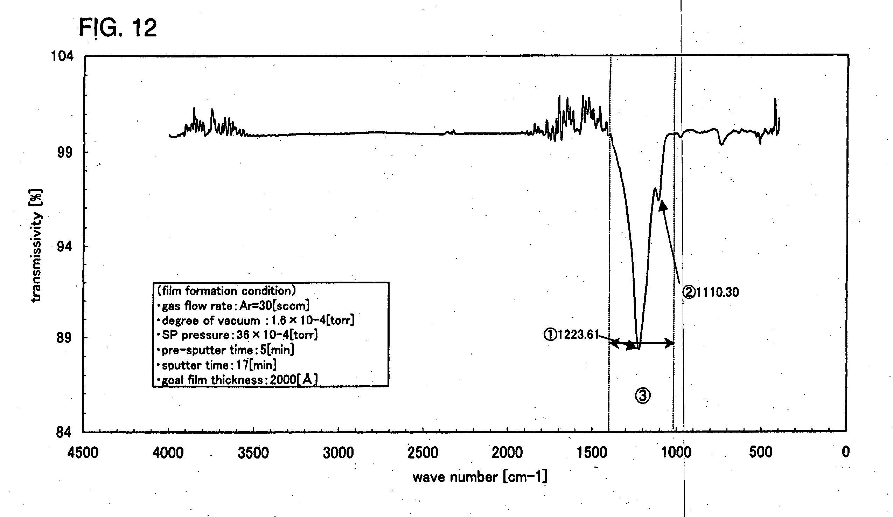

FIG. 12 is a graph showing qualitative analysis results by Fourier transform infrared spectroscopy (FT-IR). It is considered that reference numerals ①, ②, and ③ in FIG. 12 represent peaks derived from CF (1100 to 1000 cm⁻¹), CF₂. (1250 to 1070 cm⁻¹), and CF₃ (1360 to 1150 cm⁻¹). Since the peak represented by numeral 2 is distinctive, it can be thought that CF₂ is contained at high rates in the film containing fluoroplastics.

### [Embodiment7]

In the present specification, thermal conductive layers 1304, 1305 may be provided between the device formation layer 1301 and fluoroplastic films 1302, 1303 and, respectively. The thermal conductive layers radiate heat generated in the device formation layer 1301.

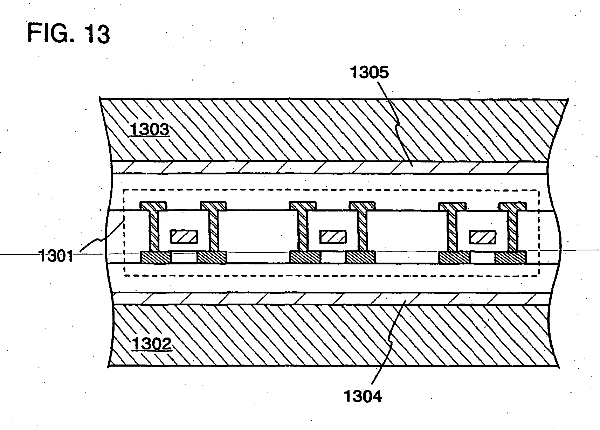

As shown in FIG. 13, thermal conductive layers 1304, 1305 are formed in contact with the device formation layer 1301 including a semiconductor device, a display device, a light-emitting device each of which is composed of a plurality of TFTs.

The thermal conductive layer 1304 is formed of a film having thermal conductivity, specifically, aluminum nitride (AlN), aluminum nitride oxide (AlNxOy (X>Y)), boron phosphide (BP), boron nitride (BN), or diamond like carbon (DLC). Or the thermal conductive layer 1304 may be formed by a lamination layer of these films.

A method for forming the thermal conductive layer 1304, sputtering, vapor deposition, CVD, or the like, can be used.

For example, in case of forming the thermal conductive layer 1304 by AlN (aluminum nitride), the layer is deposited by using AlN target under the atmosphere composed of mixed gas of argon gas and nitride gas. In addition, the layer can be deposited using aluminum (Al) target under the atmosphere of nitride gas.

With respect to the formation of the thermal conductive layers 1304, 1305, the thermal conductive layer 1304 is formed immediately prior to forming the fluoroplastic film 1302, and the thermal conductive layer 1305 is formed immediately prior to forming the fluoroplastic film 1303.

Though the case that the thermal conductive layers 1304, 1305 are formed to sandwich the device formation layer 1301 is described, the thermal conductive layer may be formed either side of the device formation layer.

By implementing the present invention, the thin film of a semiconductor device, a display device, or a light-emitting device can be formed to be lightweight, flexible, and to have a curved surface. Further, moisture, oxygen, or the like from outside can be prevented from penetrating into a device formation layer, and so the deterioration of the device characteristics can be prevented.

## Claims

1. A light-emitting device comprising:
a device formation layer comprising:
a thin film transistor (811, 812) formed over a first insulating film;
an interlayer insulating film formed over the thin film transistor (811, 812); and
a first electrode (813) electrically connected to the thin film transistor (811, 812) via the interlayer insulating film;
an electroluminescent layer (816) formed over the first electrode (813); and
a second electrode (817) formed over the electroluminescent layer (813);
a first fluoroplastic film (810) formed in contact with the first insulating film; and
a second fluoroplastic film (804) formed over the second electrode (817),
wherein the second fluoroplastic film (804) is in contact with the first fluoroplastic film (810).

2. A light-emitting device according to claim 1, wherein the light-emitting device is one selected from the group consisting of a prepaid card, a credit card, a driver's license, and a wearable computer.

3. A method for manufacturing a semiconductor device comprising:
forming a device formation layer (204) including a plurality of thin film transistors (301, 302) over a first substrate (201);
forming a first adhesive layer (207) in contact with the device formation layer (204);
bonding a second substrate (206) to the first adhesive layer (207), and sandwiching the device formation layer (204) between the first substrate (201) and the second substrate (206);
splitting and removing the first substrate (201) from the device formation layer (204) by a physical means;
forming a first fluoroplastic film (209) over an exposed surface by sputtering;
bonding a third substrate (210) to the first fluoroplastic film (209) with a second adhesive layer (211) interposed therebetween;
splitting and removing the first adhesive layer (207) and the second substrate (206) from the device formation layer (204);
forming a second fluoroplastic film (212) over an exposed surface of the device formation layer (204) by sputtering; and
splitting and removing the second adhesive layer (211) and the third substrate (210) from the device formation layer (204).

4. A method for manufacturing a semiconductor device according to claim 3, wherein each of the first adhesive layer (207) and the second adhesive layer (211) is formed by using a material that its adhesiveness weaken by light irradiation or a material that is soluble in water.

5. A light-emitting device according to claim 1, wherein the thin film transistor comprises a semiconductor layer including a source region, a drain region, and a channel formation region, a gate electrode adjacent to the semiconductor layer with a gate insulating film interposed therebetween, and a wiring electrically connected to at least one of the source region and the drain region.

6. A light-emitting device according to claim 1, wherein the device formation layer has a thickness of 50 µm or less.

7. A light-emitting device according to claim 1, wherein each of the first fluoroplastic film and the second fluoroplastic film comprises one selected from the group consisting of polyethylene containing fluorine, polypropylene containing fluorine, polyvinylene containing fluorine, and a copolymer of these compounds.

8. A light-emitting device according to claim 1, further comprising a thermal conductive layer is formed in contact with a surface of the device formation layer.

9. A method for manufacturing a semiconductor device according to claim 3, further comprising the steps of:
forming a metal layer (202) over the first substrate (201); and
forming an oxide layer (203) over the metal layer (202),
wherein the device formation layer is formed over the oxide layer (203).

10. A method for manufacturing a semiconductor device according to claim 3, wherein the step of forming the device formation layer comprises the steps of:
forming a first insulating film (504) over the first substrate (500, 201);
forming semiconductor layers (505, 506) over the first insulating film (504); and
forming the plurality of thin film transistors (601, 602, 301, 302) using the semiconductor layers (505, 506).

11. A method for manufacturing a semiconductor device according to claim 3, wherein the step of forming the device formation layer comprises the steps of:
forming the plurality of thin film transistors (811, 812, 301, 302);
forming a first electrode (813) electrically connected to at least one of the plurality of thin film transistors (811, 812, 301, 302);
forming an electroluminescent layer (816) over the first electrode (813); and
forming a second electrode (817) over the electroluminescent layer (816).

## Patentansprüche

1. Lichtemittierende Vorrichtung, die umfasst:
eine Bauteilbildungsschicht, die umfasst:
einen Dünnschichttransistor (811, 812), der über einem ersten Isolierfilm ausgebildet ist;
einen Zwischenschichtisolierfilm, der über dem Dünnschichttransistor (811, 812) ausgebildet ist; und
eine erste Elektrode (813), die elektrisch mit dem Dünnschichttransistor (811, 812) durch den Zwischenschichtisolierfilm verbunden ist;
eine Elektrolumineszenzschicht (816), die über der ersten Elektrode (813) ausgebildet ist; und
eine zweite Elektrode (817), die über der Elektrolumineszenzschicht (813) ausgebildet ist;
einen ersten Fluorkunststoff-Film (810), der in Kontakt mit dem ersten Isolierfilm ausgebildet ist; und
einen zweiten Fluorkunststoff-Film (804), der über der zweiten Elektrode (817) ausgebildet ist,
wobei der zweite Fluorkunststoff-Film (804) in Kontakt mit dem ersten Fluorkunststoff-Film (810) steht.

2. Lichtemittierende Vorrichtung nach Anspruch 1, wobei die lichtemittierende Vorrichtung aus der Gruppe ausgewählt wird, die aus einer Guthabenkarte, einer Kreditkarte, einem Führerschein und einem tragbaren Computer besteht.

3. Verfahren zum Herstellen einer Halbleitervorrichtung, wobei das Verfahren umfasst:
Ausbilden einer Bauteilbildungsschicht (204), die eine Vielzahl von Dünnschichttransistoren (301, 302) aufweist, über einem ersten Substrat (201);
Ausbilden einer ersten Haftschicht (207) in Kontakt mit der Bauteilbildungsschicht (204);
Bondieren eines zweiten Substrats (206) an der ersten Haftschicht (207) und Einbringen der Bauteilbildungsschicht (204) zwischen dem ersten Substrat (201) und dem zweiten Substrat (206);
Trennen und Entfernen des ersten Substrats (201) von der Bauteilbildungsschicht (204) durch ein physikalisches Mittel;
Ausbilden eines ersten Fluorkunststoff-Films (209) über einer freigelegten Oberfläche durch Sputtern;
Bondieren eines dritten Substrats (210) an dem ersten Fluorkunststoff-Film (209), wobei eine zweite Haftschicht (211) dazwischen liegt;
Trennen und Entfernen der ersten Haftschicht (207) und des zweiten Substrats (206) von der Bauteilbildungsschicht (204);
Ausbilden eines zweiten Fluorkunststoff-Films (212) über einer freigelegten Oberfläche der Bauteilbildungsschicht (204) durch Sputtern; und
Trennen und Entfernen der zweiten Haftschicht (211) und des dritten Substrats (210) von der Bauteilbildungsschicht (204).

4. Verfahren zum Herstellen einer Halbleitervorrichtung nach Anspruch 3, wobei sowohl die erste Haftschicht (207) als auch die zweite Haftschicht (211) unter Verwendung eines Materials, dessen Klebrigkeit durch Lichtbestrahlung geschwächt wird, oder eines Materials, das löslich in Wasser ist, ausgebildet werden.

5. Lichtemittierende Vorrichtung nach Anspruch 1, wobei der Dünnschichttransistor umfasst: eine Halbleiterschicht, die einen Source-Bereich, einen Drain-Bereich und einen Kanalbildungsbereich aufweist, eine Gate-Elektrode, die an die Halbleiterschicht angrenzt, wobei ein Gate-Isolierfilm dazwischen liegt, und eine Leitung, die elektrisch mit zumindest einem des Source-Bereichs und des Drain-Bereichs verbunden ist.

6. Lichtemittierende Vorrichtung nach Anspruch 1, wobei die Bauteilbildungsschicht eine Dicke von 50 µm oder weniger hat.

7. Lichtemittierende Vorrichtung nach Anspruch 1, wobei jeder des ersten Fluorkunststoff-Films und des zweiten Fluorkunststoff-Films eines umfasst, das aus der Gruppe ausgewählt wird, die aus fluorhaltigem Polyethylen, fluorhaltigem Polypropylen, fluorhaltigem Polyvinylen und einem Copolymer dieser Verbindungen besteht.

8. Lichtemittierende Vorrichtung nach Anspruch 1, die ferner eine thermisch leitende Schicht umfasst, die in Kontakt mit einer Oberfläche der Bauteilbildungsschicht ausgebildet ist.

9. Verfahren zum Herstellen einer Halbleitervorrichtung nach Anspruch 3, wobei das Verfahren ferner die folgenden Schritte umfasst:
Ausbilden einer Metallschicht (202) über dem ersten Substrat (201); und
Ausbilden einer Oxidschicht (203) über der Metallschicht (202),
wobei die Bauteilbildungsschicht über der Oxidschicht (203) ausgebildet wird.

10. Verfahren zum Herstellen einer Halbleitervorrichtung nach Anspruch 3, wobei der Schritt des Ausbildens der Bauteilbildungsschicht die folgenden Schritte umfasst:
Ausbilden eines ersten Isolierfilms (504) über dem ersten Substrat (500, 201);
Ausbilden von Halbleiterschichten (505, 506) über dem ersten Isolierfilm (504); und
Ausbilden der Vielzahl von Dünnschichttransistoren (601, 602, 301, 302) unter Verwendung der Halbleiterschichten (505, 506).

11. Verfahren zum Herstellen einer Halbleitervorrichtung nach Anspruch 3, wobei der Schritt des Ausbildens der Bauteilbildungsschicht die folgenden Schritte umfasst:
Ausbilden der Vielzahl von Dünnschichttransistoren (811, 812, 301, 302);
Ausbilden einer ersten Elektrode (813), die elektrisch mit zumindest einem der Vielzahl von Dünnschichttransistoren (811, 812, 301, 302) verbunden ist;
Ausbilden einer Elektrolumineszenzschicht (816) über der ersten Elektrode (813); und
Ausbilden einer zweiten Elektrode (817) über der Elektrolumineszenzschicht (816).

## Revendications

1. Un dispositif émetteur de lumière comprenant:
une couche de formation de dispositif comprenant:
un transistor en couche mince (811, 812) formé au-dessus d'un premier film isolant ;
un film isolant intercalaire formé au-dessus du transistor en couche mince (811, 812) ; et
une première électrode (813) électriquement connectée au transistor en couche mince (811, 812) à travers le film isolant intercalaire ;
une couche électroluminescente (816) formée au-dessus de la première électrode (813) ; et
une seconde électrode (817) formée au-dessus de la couche électroluminescente (813) ;
un premier film plastique fluoré (810) formé en contact avec le premier film isolant ; et
un second film plastique fluoré (804) formé au-dessus de la seconde électrode (817),
dans lequel le second film plastique fluoré (804) est en contact avec le premier film plastique fluoré (810).

2. Un dispositif émetteur de lumière selon la revendication 1, dans lequel le dispositif émetteur de lumière est sélectionné dans le groupe consistant en une carte prépayée, une carte de crédit, un permis de conduire, et un ordinateur portable.

3. Une méthode pour fabriquer un dispositif semi-conducteur comprenant :
former une couche de formation de dispositif (204) incluant une pluralité de transistors en couche mince (301, 302) au-dessus d'un premier substrat (201) ;
former une première couche adhésive (207) en contact avec la couche de formation de dispositif (204) ;
coller un second substrat (206) à la première couche adhésive (207), et prendre en sandwich la couche de formation de dispositif (204) entre le premier substrat (201) et le second substrat (206) ;
scinder et enlever le premier substrat (201) de la couche de formation de dispositif (204) par un moyen physique ;
former un premier film plastique fluoré (209) au-dessus d'une surface exposée par pulvérisation ;
coller un troisième substrat (210) au premier film plastique fluoré (209) avec une second couche adhésive interposée entre le troisième substrat (210) et le premier film plastique fluoré (209) ;
scinder et enlever la première couche adhésive (207) et le second substrat (206) de la couche de formation de dispositif (204) ;
former un second film plastique fluoré (212) au-dessus d'une surface exposée de la couche de formation de dispositif (204) par pulvérisation; et
scinder et enlever la seconde couche adhésive (211) et le troisième substrat (210) de la couche de formation de dispositif (204).

4. Une méthode pour fabriquer un dispositif semi-conducteur selon la revendication 3, dans laquelle chacune de la première couche adhésive (207) et la seconde couche adhésive (211) est formée en utilisant un matériau à capacité d'adhésion affaiblie par irradiation lumineuse ou un matériau soluble dans l'eau.

5. Un dispositif émetteur de lumière selon la revendication 1, dans lequel le transistor en couche mince comprend une couche semi-conductrice incluant une région de source, une région de drain, et une région de formation de canal, une électrode de grille adjacente à la couche semi-conductrice avec un film d'isolation de grille interposé entre l' électrode de grille et la couche semi-conductrice, et une piste de connexion électriquement connectée à au moins l'une de la région de source et la région de drain.

6. Un dispositif émetteur de lumière selon la revendication 1, dans lequel la couche de formation de dispositif a une épaisseur de 50 µm ou moins.

7. Un dispositif émetteur de lumière selon la revendication 1, dans lequel chacun du premier film plastique fluoré et du second film plastique fluoré comprend un élément sélectionné parmi le groupe consistant en polyéthylène contenant du fluor, polypropylène contenant du fluor, polyvinylène contenant du fluor, et un copolymère de ces composés.

8. Un dispositif émetteur de lumière selon la revendication 1, comprenant en plus une couche thermiquement conductrice formée en contact avec une surface de la couche de formation de dispositif.

9. Une méthode pour fabriquer un dispositif semi-conducteur selon la revendication 3, comprenant en plus les étapes de :
former une couche de métal (202) au-dessus du premier substrat (201) ; et
former une couche d'oxyde (203) au-dessus de la couche de métal (202),
dans laquelle la couche de formation de dispositif est formée au-dessus de la couche d'oxyde (203).

10. Une méthode pour fabriquer un dispositif semi-conducteur selon la revendication 3, dans laquelle l'étape de former la couche de formation de dispositif comprend les étapes de :
former un premier film isolant (504) au-dessus du premier substrat (500, 201) ;
former des couches semi-conductrices (505, 506) au-dessus du premier film isolant (504) ; et
former la pluralité de transistors en couche mince (601, 602, 301, 302) en utilisant les couches semi-conductrices (505, 506).

11. Une méthode pour fabriquer un dispositif semi-conducteur selon la revendication 3, dans laquelle l'étape de former la couche de formation de dispositif comprend les étapes de :
former la pluralité de transistors en couche mince (811, 812, 301, 302) ;
former une première électrode (813) électriquement connectée à au moins l'un de la pluralité de transistors en couche mince (811, 812, 301, 302) ;
former une couche électroluminescente (816) au-dessus de la première électrode (813) ; et
former une second électrode (817) au-dessus de la couche électroluminescente (816).
